(19) Europäisches Patentamt
European Patent Office
Office européen des brevets

(11) **EP 3 940 740 A1**

(12) **EUROPEAN PATENT APPLICATION**

(43) Date of publication:
**19.01.2022 Bulletin 2022/03**

(21) Application number: **20186333.9**

(22) Date of filing: **16.07.2020**

(51) International Patent Classification (IPC):
**H01J 37/075** (2006.01)    **H01J 3/02** (2006.01)
**H01J 37/073** (2006.01)    **H01J 1/14** (2006.01)
**H01J 1/304** (2006.01)

(52) Cooperative Patent Classification (CPC):
**H01J 37/075; H01J 1/14; H01J 1/3042;**
**H01J 3/022; H01J 3/024; H01J 37/073;**
H01J 2201/196; H01J 2201/2889; H01J 2201/2892;
H01J 2201/30407; H01J 2201/30426;
H01J 2201/30449; H01J 2201/30453;
H01J 2237/06308; H01J 2237/06325

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **VAN SOEST, Jurgen**
**5500 AH Veldhoven (NL)**

(74) Representative: **ASML Netherlands B.V.**
**Corporate Intellectual Property**
**P.O. Box 324**
**5500 AH Veldhoven (NL)**

(54) **EMITTER FOR EMITTING CHARGED PARTICLES**

(57)    An emitter is configured to emit charged particles. The emitter comprises a body, a metal layer and a charged particle source layer. The body has a point. The metal layer is of a first metal on at least the point. The charged particle source layer is on the metal layer. The point comprises a second metal other than the first metal.

Fig. 4

Fig. 5

## Description

FIELD

The embodiments provided herein generally relate the provision of an emitter configured to emit charged particles. Embodiments provide a charged particle source, an illumination apparatus, a charged particle beam tool and a charged particle beam inspection apparatus. Embodiments also provide a method for making an emitter and a method for emitting a beam of charged particles.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Another application for a charged particle beam is lithography. The charged particle beam reacts with a resist layer on the surface of a substrate. A desired pattern in the resist can be created by controlling the locations on the resist layer that the charged particle beam is directed towards. A charged particle apparatus may be an apparatus for generating and/or projecting one or more beams of charged particles.

"A high-brightness large-diameter graphene coated point cathode field emission electron source" by Shao et al (Nature Communications, 29 March 2018) discloses a few layer graphene-coated nickel wire cathode as the emitter for an electron source.

There is a general need for improving an emitter, for example to increase stability and/or total emitted current for a given brightness of a current of emitted charged particles and/or increase reproducibility of making the emitter.

SUMMARY

According to a first aspect of the invention, there is provided an emitter configured to emit charged particles, the emitter comprising: a body having a point; a metal layer of a first metal on at least the point; and a charged particle source layer on the metal layer, wherein the point comprises a second metal other than the first metal.

According to a second aspect of the invention, there is provided a method for making an emitter configured to emit charged particles, the method comprising: providing a body having a point; disposing a metal layer of a first metal on at least the point; and forming a charged particle source layer on the metal layer, wherein the body comprises a second metal other than the first metal.

According to a third aspect of the invention, there is provided a method of emitting a beam of charged particles, the method comprising: providing an emitter configured to emit charged particles, the emitter comprising a charged particle source layer on a metal at a point of a body of the emitter; and heating the point to a temperature of greater than 500°C so as to promote thermionic emission.

According to a third aspect of the invention, there is provided an emitter configured to emit charged particles, the emitter comprising: a body having a point; a metal layer on at least the point; and a charged particle source layer on the metal layer, wherein the point comprises a different metal from the metal layer

Advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of FIG. 1.

FIG. 3 is a schematic diagram of exemplary multi-beam apparatus illustrating an exemplary configuration of source conversion unit of the exemplary charged particle beam inspection apparatus of FIG. 1.

FIG. 4 is a schematic diagram of an emitter for charged particle emission according to an embodiment of the invention.

FIG. 5 is a schematic diagram of a charged particle source according to an embodiment of the invention.

FIGs. 6 to 8 are schematic diagrams showing different stages of a method of manufacturing an emitted structure according to an embodiment of the invention.

FIG. 9 is a schematic diagram of restoring the graphene-based layer of the emitter according to an embodiment of invention.

FIG. 10 is a schematic diagram of an emitter according to an embodiment of the invention.

FIG.11 is a schematic diagram of an emitter with a suppressor according to an embodiment of the invention.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The reduction of the physical size of devices, and enhancement of the computing power of electronic devices may be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. The semiconductor IC manufacturing is a complex and time-consuming process. Errors may cause device failure. The goal of the manufacturing process is to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

While high process yield is desirable in an IC chip manufacturing facility, maintaining a high substrate (i.e. wafer) throughput, defined as the number of substrates processed per hour, is also essential. High process yield and high substrate throughput may be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. The primary electrons interact with the sample and generate interaction products, such as secondary electrons and/or backscattered electrons. The detection apparatus captures the secondary electrons and/or backscattered electrons from the sample as the sample is scanned so that the SEM may create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam may scan different parts of a sample simultaneously. A multi-beam inspection apparatus may therefore inspect a sample at a much higher speed than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

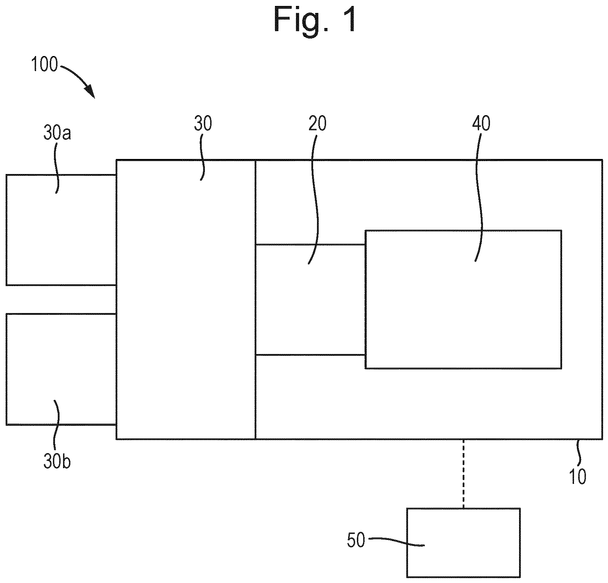

Reference is now made to FIG. 1, which is a schematic diagram illustrating an exemplary charged particle beam inspection apparatus 100. The charged particle beam inspection apparatus 100 of Fig. 1 includes a main chamber 10, a load lock chamber 20, an electron beam tool 40, an equipment front end module (EFEM) 30 and a controller 50.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas molecules in main chamber 10 so that the pressure around the sample reaches a second pressure lower than the first pressure. After reaching the second pressure, the sample is transported to the electron beam tool by which it may be inspected. An electron beam tool 40 may comprise either a single beam or a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in FIG. 1 as being outside of the structure that includes main chamber 10, load lock chamber 20, and EFEM 30, it is appreciated that controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

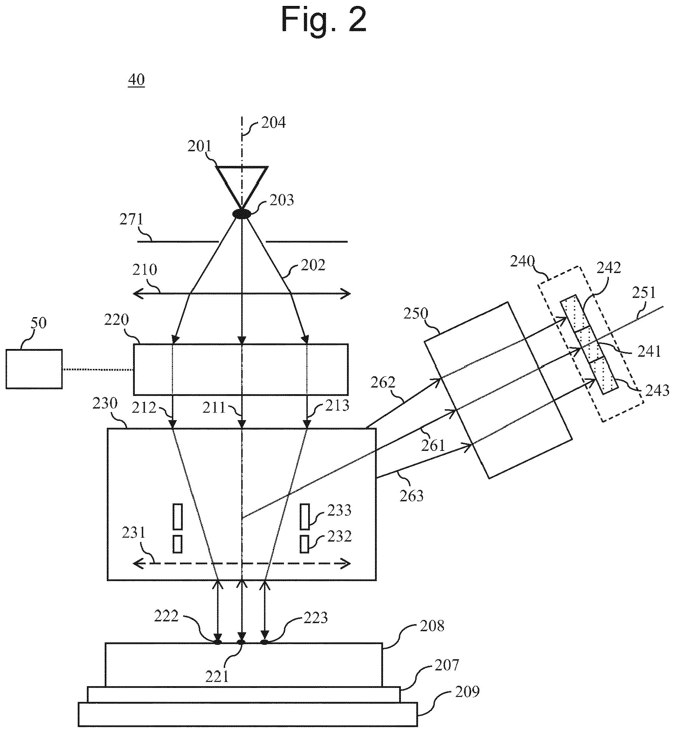

Reference is now made to FIG. 2, which is a schematic diagram illustrating an exemplary electron beam tool 40 including a multi-beam inspection tool that is part of the exemplary charged particle beam inspection apparatus 100 of FIG. 1. Multi-beam electron beam tool 40 (also referred to herein as apparatus 40) comprises an electron source 201, a gun aperture plate 271, a condenser lens 210, a source conversion unit 220, a primary projection apparatus 230, a motorized stage 209, and a sample holder 207. The electron source 201, gun aperture plate 271, condenser lens 210 and source conversion unit 220 are the components of an illumination apparatus comprised by the multi-beam electron beam tool 40. The sample holder 207 is supported by motorized stage 209 so as to hold a sample 208 (e.g., a substrate or a mask) for inspection. Multi-beam electron beam tool 40 may further comprise a secondary projection apparatus 250 and an associated electron detection device 240. Primary projection apparatus 230 may comprise an objective lens 231. Electron detection device 240 may comprise a plurality of detection elements 241, 242, and 243. A beam separator 233 and a deflection scanning unit 232 may be positioned inside primary projection apparatus 230.

The components that are used to generate a primary beam may be aligned with a primary electron-optical axis of the apparatus 40. These components may include: the electron source 201, gun aperture plate 271, condenser lens 210, source conversion unit 220, beam separator 233, deflection scanning unit 232, and primary projection apparatus 230. Secondary projection apparatus 250 and its associated electron detection device 240 may be aligned with a secondary electron-optical axis 251 of apparatus 40.

The primary electron-optical axis 204 is comprised by the electron-optical axis of the of the part of electron beam tool 40 that is the illumination apparatus. The secondary electron-optical axis 251 is the electron-optical axis of the of the part of electron beam tool 40 that is a detection apparatus. The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

The formed primary electron beam 202 may be a single beam and a multi-beam may be generated from the single beam. At different locations along the beam path, the primary electron beam 202 may therefore be either a single beam or a multi-beam. By the time it reaches the sample, and preferably before it reaches the projection apparatus, the primary electron beam 202 is a multi-beam. Such a multi-beam may be generated from the primary electron beam in a number of different ways. For example, the multi-beam may be generated by a multi-beam array located before the cross-over 203, a multi-beam array located in the source conversion unit 220, or a multi-beam array located at any point in between these locations.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also include multiple openings for generating primary sub-beams (not shown) even before the source conversion unit 220 and may be referred to as a coulomb aperture array.

Condenser lens 210 is configured to focus (or substantially collimate) primary electron beam 202. In an embodiment, the condenser lens 210 may be designed to focus (or collimate) primary electron beam 202 to become a parallel beam and be substantially normally incident onto source conversion unit 220. Condenser lens 210 may be a movable condenser lens that may be configured so that the position of its principle plane is movable. In an embodiment, the movable condenser lens may be configured to physically move, e.g. along the optical axis 204. Alternatively, the movable condenser lens may be constituted of two or more electro-optical elements (lenses) in which the principle plane of the condenser lens moves with a variation of the strength of the individual electro-optical elements. The (movable) condenser lens may be configured to be magnetic, electrostatic or a combination of magnetic and electrostatic lenses. In a further embodiment, the condenser lens 210 may be an anti-rotation condenser lens. The anti-rotation condenser lens may be configured to keep the rotation angles unchanged when the focusing power (collimating power) of condenser lens 210 is changed and/or when the principle plane of the condenser lens moves.

In an embodiment of the source conversion unit 220, the source conversion unit 220 may comprise an image-forming element array, an aberration compensator array, a beam-limit aperture array, and a pre-bending micro-deflector array. The pre-bending micro-deflector array may, for example, be optional and may be present in an embodiment in which the condenser lens does not ensure substantially normal incidence of sub-beams originating from the coulomb aperture array onto e.g. the beam-limit aperture array, the image-forming element array, and/or the aberration compensator array. The image-forming element array may be configured to generate the plurality of sub-beams in the multi-beam path, i.e. primary sub-beams 211, 212, 213. The image forming element array may, for example, comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may, for example, comprise a field curvature compensator array (not shown) and an astigmatism compensator array (not shown). The field curvature compensator array may, for example, comprise a plurality of micro-lenses to compensate field curvature aberrations of the primary sub-beams 211, 212, and 213. The astigmatism compensator array may comprise a plurality of micro-stigmators to compensate astigmatism aberrations of the primary sub-beams 211, 212, and 213. The beam-limit aperture array may be configured to define the diameters of individual primary sub-beams 211, 212, and 213. FIG. 2 shows three primary sub-beams 211, 212, and 213 as an example, and it should be understood that source conversion unit 220 may be configured to form any number of primary sub-beams. Controller 50 may be connected to various parts of charged particle beam inspection apparatus 100 of FIG. 1, such as source conversion unit 220, electron detection device 240, primary projection apparatus 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power (collimating power) of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams.

Objective lens 231 may be configured to focus sub-beams 211, 212, and 213 onto the sample 208 for inspection and, in the current embodiment, may form three probe spots 221, 222, and 223 on the surface of sample 208.

Beam separator 233 may be, for example, a Wien filter comprising an electrostatic dipole field and a magnetic dipole field (not shown in FIG. 2).

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. In the current embodiment, the secondary electrons propagate in three secondary electron beams 261, 262, and 263. The secondary electron beams 261, 262, and 263 typically have secondary electrons (having electron energy $\leq 50eV$) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection apparatus 250. The secondary projection apparatus 250 subsequently focuses the path of secondary electron beams 261, 262, and 263 onto a plurality of detection regions 241, 242, and 243 of electron detection device 240. The detection regions may, for example, be the separate detection elements 241, 242, and 243 that are arranged to detect corresponding secondary electron beams 261, 262, and 263. The detection regions may generate corresponding signals which are, for example, sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, may be used in combination with corresponding scan path data of each of primary sub-beams 211, 212, and 213 incident on the sample surface, to reconstruct images of the sample structures under inspection. The reconstructed images may be used to reveal various features of the internal or external structures of sample 208. The reconstructed images may thereby be used to reveal any defects that may exist in the sample.

The controller 50 may, e.g. further control the motorized stage 209 to move the sample 208 during, before or after inspection of the sample 208. In an embodiment, the controller 50 may enable the motorized stage 209 to move sample 208 in a direction, e.g. continuously, for example at a constant speed, at least during sample inspection. The controller 50 may control movement of the motorized stage 209 so that the speed of the movement of the sample 208 changes, e.g. dependent on various parameters. For example, the controller may control the stage speed (including its direction) depending on the characteristics of the inspection steps of scanning process.

Although FIG. 2 shows that apparatus 40 uses three primary electron sub-beams, it is appreciated that apparatus 40 may use two or more number of primary electron sub-beams. The present disclosure does not limit the number of primary electron beams used in apparatus 40.

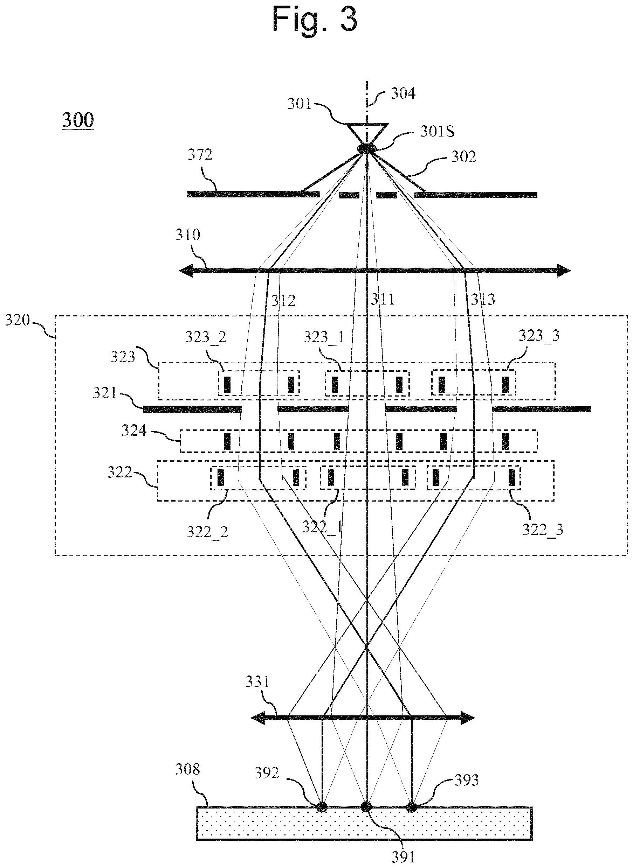

Reference is now made to FIG. 3, which is a schematic diagram of exemplary multi-beam apparatus illustrating an exemplary configuration of source conversion unit of the exemplary charged particle beam inspection apparatus of FIG. 1. The apparatus 300 may comprise an election source 301, a pre-sub-beam-forming aperture array 372 (further also referred to as coulomb aperture array 372), a condenser lens 310 (similar to condenser lens 210 of FIG. 2), a source conversion unit 320, an objective lens 331 (similar to objective lens 231 of FIG. 2), and a sample 308 (similar to sample 208 of FIG. 2). The election source 301, the coulomb aperture array 372, the condenser lens 310 may be the components of an illumination apparatus comprised by the apparatus 300. The source conversion unit 320 and objective lens 331 may be the components of a projection apparatus comprised by the apparatus 300. The source conversion unit 320 may be similar to source conversion unit 220 of FIG. 2 in which the image-forming element array of FIG. 2 is image-forming element array 322, the aberration compensator array of FIG. 2 is aberration compensator array 324, the beam-limit aperture array of FIG. 2 is beam-limit aperture array 321, and the pre-bending micro-deflector array of FIG. 2 is pre-bending micro-deflector array 323. The election source 301, the coulomb aperture array 372, the condenser lens 310, the source conversion unit 320, and the objective lens 331 are aligned with a primary electron-optical axis 304 of the apparatus. The electron source 301 generates a primary-electron beam 302 generally along the primary electron-optical axis 304 and with a source crossover (virtual or real) 301S. The coulomb aperture array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the coulomb aperture array 372 of a pre-sub-beam-forming mechanism. Although three sub-beams and their paths are referred to in the previous and following description, it should be understood that the description is intended to apply an apparatus, tool, or system with any number of sub-beams.

The source conversion unit 320 may include a beamlet-limit aperture array 321 with beam-limit apertures configured to define the outer dimensions of the sub-beams 311, 312, and 313 of the primary electron beam 302. The source conversion unit 320 may also include an image-forming element array 322 with image-forming micro-deflectors, 322_1, 322_2, and 322_3. There is a respective micro-deflector associated with the path of each sub-beam. The micro-deflectors 322_1, 322_2, and 322_3 are configured to deflect the paths of the sub-beams 311, 312, and 313 towards the electron-optical axis 304. The deflected sub-beams 311, 312 and 313 form virtual images (not shown) of source crossover 301S. In the current embodiment, these virtual images are projected onto the sample 308 by the objective lens 331 and form probe spots thereon, which are the three probe spots, 391, 392, and 393. Each probe spot corresponds to the location of incidence of a sub-beam path on the sample surface. The source conversion unit 320 may further comprise an aberration compensator array 324 configured to compensate aberrations that may be present in each of the sub-beams. The aberration compensator array 324 may, for example, include a field curvature compensator array (not shown) with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source conversion unit 320 may further comprise a pre-bending micro-deflector array 323 with pre-bending micro-deflectors 323_1, 323_2, and 323_3 to bend the sub-beams 311, 312, and 313 respectively. The pre-bending micro-deflectors 323_1, 323_2, and 323_3 may bend the path of the sub-beams onto the beamlet-limit aperture array 321.

The image-forming element array 322, the aberration compensator array 324, and the pre-bending micro-deflector array 323 may comprise multiple layers of sub-beam manipulating devices, some of which may be in the form or arrays, for example: micro-deflectors, micro-lenses, or micro-stigmators.

In the current example of the source conversion unit 320, the sub-beams 311, 312 and 313 of the primary electron beam 302 are respectively deflected by the micro-deflectors 322_1, 322_2 and 322_3 of image-forming element array 322 towards the primary electron-optical axis 304. It should be understood that the sub-beam 311 path may already correspond to the electron-optical axis 304 prior to reaching micro-deflector 322_1, accordingly the sub-beam 311 path may not be deflected by micro-deflector 322_1.

The objective lens 331 focuses the sub-beams onto the surface of the sample 308, i.e., it projects the three virtual images onto the sample surface. The three images formed by three sub-beams 311 to 313 on the sample surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393.

In an embodiment of a multi-beam inspection tool 300 as shown in Fig. 3 the beam path of the secondary electrons, beam separator (similar as Wien filter 233), secondary projection optics (similar as secondary projection optics 250 of Fig. 2) and electron detection device (similar as electron detection device 240) have been omitted for clarity reasons. Is should be clear however that similar beam separator, secondary projection optics and electron detection device may be present in the current embodiment of Fig. 3 to register and generate an image of the sample surface using the secondary electrons or backscattered electrons.

At least some of the above-described components in FIG. 2 and FIG. 3 may individually, or in combination with each other, be referred to as a manipulator array, or manipulator, because they manipulate one or more beams, or sub-beams, of charged particles.

The above described embodiments of multi-beam inspection tools comprise a multi-beam charged particle apparatus, that may be referred to as a multi-beam charged particle optical apparatus, with a single source of charged particles. The multi-beam charged particle apparatus comprises an illumination apparatus and a projection apparatus. The illumination apparatus may generate a multi-beam of charged particles from the beam of electrons from the source. The projection apparatus projects a multi-beam of charged particles towards a sample. At least part of the surface of a sample may be scanned with the multi-beam of charged particles.

A multi-beam charged particle apparatus comprises one or more electron-optical devices for manipulating the sub-beams of the multi-beam of charged particles. The applied manipulation may be, for example, a deflection of the paths of sub-beams and/or a focusing operation applied to the sub-beams. The one or more electron-optical devices may comprise MEMS (Micro-Electro-Mechanical Systems).

The charged particle apparatus may comprise beam path manipulators located up-beam of the electron-optical device and, optionally, in the electron-optical device. Beam paths may be manipulated linearly in directions orthogonal to the charged particle axis, i.e. optical axis, by, for example, two electrostatic deflector sets operating across the whole beam. The two electrostatic deflector sets may be configured to deflect the beam path in orthogonal directions. Each electrostatic deflector set may comprise two electrostatic deflectors located sequentially along the beam path. The first electrostatic deflector of each set applies a correcting deflection and the second electrostatic deflector restores the beam to the correct angle of incidence on the electron-optical device. The correcting deflection applied by the first electrostatic deflector may be an over correction so that the second electrostatic deflector can apply a deflection for ensuring the desired angle of incidence to the MEMS. The location of the electrostatic deflector sets could be at a number of locations up-beam of the electron-optical device. Beam paths may be manipulated rotationally. Rotational corrections may be applied by a magnetic lens. Rotational corrections may additionally, or alternatively, be achieved by an existing magnetic lens such as the condenser lens arrangement.

In an embodiment a charged particle apparatus may comprise alternative and/or additional components on the charged particle path, such as lenses and other components some of which have been described earlier with reference to FIGs. 1 to 3. In particular, embodiments include a charged particle projection apparatus that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The condenser lenses, objective lenses and/or detector may be formed as MEMS or CMOS devices.

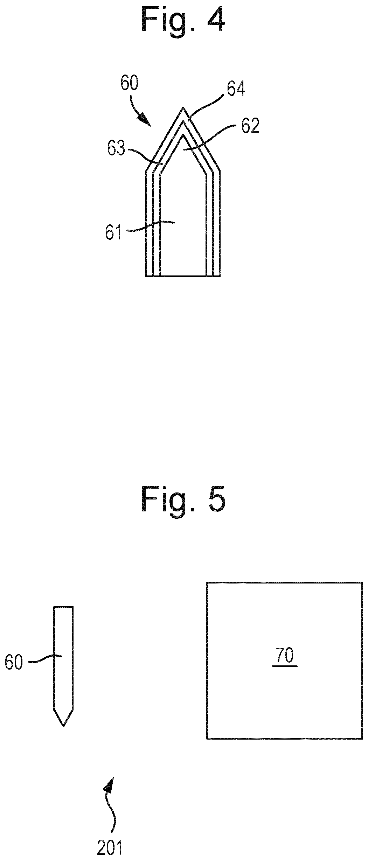

FIG. 4 is a schematic diagram of an emitter 60 according to an embodiment of the invention. The emitter 60 is configured to emit charged particles. In an embodiment, the emitter 60 is part of a charged particle source 201, 301. For example, in an embodiment, the emitter 60 is part of a charged particle source 201, 301 of an illumination apparatus of a charged particle beam tool such as the electron beam tool 40 shown in FIG. 2 or FIG. 3. In an alternative embodiment, the emitter 60 is part of an apparatus for lithography, such as a source.

As shown in FIG. 4, in an embodiment the emitter 60 comprises a body 61. The body 61 has a point 62. The point 62 may be a tip. In an embodiment the body 61 has an elongate shape with one end of the elongate shape being pointed. The point 62 forms the pointed end of the body 61. In an embodiment, the body 61 defines the shape of the surface from which charged particles are emitted. The shape of the body 61 contributes to defining the direction in which charged particles are emitted from the emitter 60. The cross-sectional shape of the body 61 is not limited to the shapes described here. The body 61 may have other cross-sectional shapes known to the skilled person. The cross-sectional shape may be of any shape.. In an embodiment the cross-sectional shape is approximately circular. However, other shapes are also possible, for example hexagonal. The body may comprise metal.

As shown in FIG. 4, in an embodiment the emitter 60 comprises a metal layer 63. The metal layer 63 comprises a metal, referred to as a first metal. The metal layer 63 is on at least the point 62 of the body 61. The metal layer 63 covers the point of the body 61. As shown in FIG. 4, in an embodiment the metal layer 63 is disposed along the sides of the elongate shape of the body 61. However, in an alternative embodiment the metal layer 63 is provided on a smaller portion of the surface of the body. In an embodiment the metal layer 63 is provided on the point 62. The sides of the body 61 may define the surface of the emitter 60; that is the side of the body may not covered by the metal layer 63. As shown in FIG. 4, in an embodiment the end of the body 61 opposite the point 62 defines the surface; that is the surface is not provided with the metal layer 63. In an alternative embodiment, the metal layer 63 is additionally provided at the end of the body 61 opposite to the point 62. The body 61 may be completely covered by the metal layer 63.

As shown in FIG. 4, in an embodiment the emitter 60 comprises a charged particle source layer 64. The charged particle source layer 64 is the source of the charged particles. The charged particle source layer 64 is on the metal layer 63. As shown in FIG. 4, in an embodiment the charged particle source layer 64 is on the metal layer 63 at least at the point 62 of the body 61. In an embodiment the charged particle source layer 64 forms the surface from which charged particles are emitted from the emitter 60.

In an embodiment the charged particle source layer 64 comprises a graphene-based layer. Graphene as used in embodiments of the invention has a relatively low work function. The work function is the minimum thermodynamic work needed to remove a charged particle from a solid to a point in the vacuum immediately outside the solid surface. In an embodiment the charged particle source layer 64 is configured to provide chemical and mechanical protection for the emitter 60. Graphene has a relatively high mechanical strength combined with electrical conductivity and thermal stability.

However, it is not essential for the charged particle source layer 64 to comprise a graphene-based layer. In an embodiment the charged particle source layer 64 comprises a structured material. The structured material may be based on graphene. In an embodiment the charged particle source layer 64 comprises a two-dimensional compound having metallic atoms in its lattice.

In an embodiment, the point 62 comprises metal, referred to a as 'a second metal. The second metal is other than the first metal of the metal layer 63. The two metals may have different physical properties. In an embodiment, the second metal has a higher melting point than the first metal of the metal layer 63. The metal of the point 62 is configured to conduct heat to the emitting surface formed by the charged particle source layer 64 on the metal layer 63. The point 62 can be heated to relatively high temperatures, for example above 500°C.

By providing that the emitter 60 is suitable to be heated to high temperatures, contaminants at the surface of the emitter 60 can be removed by the heating. By removing contaminants, the current of emitted charged particles is more stable.

In an embodiment, there is provided a method of emitting a beam of charged particles. The emitter 60 comprises the charged particle source layer 64 on a metal at the point 62 of the body 61 of the emitter 60. In an embodiment, the method of generating the beam of charged particles comprises heating the point 62 to a temperature of greater than 500°C so as to promote thermionic emission. The heat conducted from the point 62 to the charged particle source layer 64 provides the energy for the charged particles to overcome the work function of the charged particle source layer 64. In an embodiment, the point 62 is heated to a temperature of at least 700°C, optionally at least 1000°C, optionally at least 1500°C and optionally at least 2000°C.

By providing that the second metal of the point 62 is different from the first metal of the metal layer 63, the metals can be selected to have different properties. For example, the second metal may be selected to be mechanically stable at high temperatures. The first metal may be selected for its properties in helping formation of the charged particle source layer 64.

By providing that the second metal of the point 62 has a higher melting point than the first metal of the metal layer 63, the emitter 60 can be used for thermionic emission without unduly deteriorating the emitter 60. The point 62 can be heated to relatively high temperatures without the point 62 of the body 61 deforming (e.g. flattening). The point 62 can be heated to relatively high temperatures while maintaining the directionality of the emitted beam of charged particles.

By providing that the emitter 60 is suitable for thermionic emission, the stability of the current of emitted charged particles is greater. The current stability for charged particles is greater for thermionic emission than for cold field emission. An embodiment of the invention is expected to improve current stability of the beam of charged particles. An embodiment of the invention is expected to achieve improved current stability while maintaining directionality of the beam of emitted charged particles.

In an embodiment, the metal of the point 62 is suitable for being heated to high temperatures without unduly deteriorating. For example, the metal of the point 62 can be heated without cracking or shattering. The metal of the point 62 has high thermal conductivity. Materials having an appropriately high mechanical stability at high temperatures can be used for the body 61 and point 62. In an embodiment the body 61 comprises a refractory metal. A refractory metal is a heat-resistant metal. In an embodiment the body 61 comprises a refractory metal, namely a metal selected from the group consisting of tungsten, molybdenum, tantalum, niobium, rhenium, titanium, vanadium, chromium, zirconium, hafnium, ruthenium, rhodium, osmium and iridium. In an embodiment the body 61 comprises a metal selected from the group consisting of tungsten, molybdenum, tantalum, niobium and rhenium.

In an embodiment the point 62 comprises tungsten. In an embodiment the body 61 is made of tungsten. Bodies made of tungsten are relatively cheap and readily available. An embodiment of the invention is expected to improve the emission current stability without unduly increasing the cost of manufacturing the emitter 60. In an alternative embodiment, the point 62 comprises molybdenum. In an embodiment, the body 61 is made of molybdenum. A metal such as tungsten or molybdenum is thermally more stable than other material such as silicon. For example, silicon may shatter when heated to the temperatures required for significant thermionic emission.

In an embodiment the material of the point 62 has a lower remanence than the metal of the metal layer 63. When charged particles are emitted from the emitter 60, remnant magnetism may be caused in the emitter 60. For example, the point 62 may have a remnant magnetism as a result of the charged particle emission. Other components of the apparatus in which the emitter 60 is used, e.g. lenses, may cause a remnant magnetism in the emitter 60.

By providing that the material of the point 62 has a lower remanence than the metal of the metal layer 63, the potential remnant magnetism in the point 62 is reduced and/or limited. By reducing the potential remnant magnetism of the point 62, the effect of magnetism on the direction of the emitted beam of charged particles is reduced. An embodiment of the invention is expected to improve accuracy of the direction of the emitted beam of charged particles.

For example, in an embodiment the target direction for the beam of charged particles is along the axis of the elongate body 62. Any remnant magnetism in the point 62 can undesirably change the direction away from the axial direction. An embodiment of the invention is expected to decrease deviation of the emitted beam of charged particles away from the axial direction.

In an embodiment, the metal layer 63 comprises nickel. By providing that the charged particle source layer 64 is on metal, the work function of the charged particle source layer 64 is reduced. By providing that the charged particle source layer 64 is on a layer of nickel, the work function of the charged particle source layer 64 is reduced. The stability of the emitted current of charged particles is increased. For example, the work function value for graphene-coated nickel has been calculated to be 1.1 eV.

In an embodiment, the charged particle source layer 64 is doped by the first metal of the metal layer 63. For example, when the metal layer 63 is nickel and the charged particle source layer 64 is a graphene-based layer, the graphene-based layer may be doped by the nickel. In an embodiment, the work function of the charged particle source layer 64 is reduced by n-type doping of graphene due to chemisorption on nickel.

In an embodiment, there is provided a method for making an emitter 60 configured to emit charged particles. The method comprises providing the body 61 having the point 62, disposing the metal layer 63 on at least the point 62, and forming the charged particle source layer 64 on the metal layer 63. In an embodiment, the charged particle source layer 64 is formed using a chemical vapor deposition (CVD) method. In an embodiment, a solid carbon source poly(methyl methacrylate) (PMMA) is used as feedstock for the CVD method. By using a CVD method, the charged particle source layer 64 can be formed while avoiding extremely high temperatures which could otherwise deform the point 62. In an embodiment, the body 61 with the metal layer 63 disposed thereon is placed in a ceramic holder in a furnace such as a tube furnace. An $Al_2O_3$ boat loaded with the feedstock is placed at the inlet slide of the tube (e.g. quartz tube), just outside of the heating zone. In an embodiment the body 61 is heated to, for example 800 to 900°C. In an embodiment the feed source is heated to about 150°C. The furnace is opened for the formation of the charged particle source layer 64 on the metal layer 63. In an embodiment, the metal layer 63 comprises nickel that catalyzes formation of the charged particle source layer 64 on the metal layer 63.

However, it is not essential for the metal layer 63 to comprise nickel. Other metals may be used, for example palladium, copper, silver, cobalt, iridium or platinum. Such metals can catalyze formation of a charged particle source layer 64 such as a graphene-based layer. Such metals can reduce the work function of the charged particle source layer 64. Chemisorption on nickel, cobalt and palladium has been found to significantly reduce the work function of graphene. Weaker adsorption on copper and silver has been found to slightly decrease the work function of graphene.

In an embodiment, the metal layer 63 has a thickness of at most 500nm, optionally at most 200nm, optionally at most 100nm, optionally at most 50nm, optionally at most 20nm, optionally at most 10nm, and optionally at most 5nm. By providing that the metal layer 63 is relatively thin, the volume of the metal layer 63 is reduced and/or limited. The potential remnant magnetism of the metal layer 63 is reduced. Any adverse effect of remnant magnetism in the metal layer 63 on the direction of the emitted beam of charged particles is reduced. In an embodiment, the metal layer 63 is disposed on at least the point 62 by a thin film deposition method. Other methods known to the skilled person may be used for depositing the metla layer 63.

As shown schematically in FIG. 5, in an embodiment a charged particle source 201 comprises the emitter 60 and an electric field generator 70. Details of the electric field generator 70 are not shown in FIG. 5. The electric field generator 70 is configured to generate an electric field relative to the emitter, for example at the point 62. In an embodiment the electric field generator 70 comprises at least one electric component and/or a power supply. The electric field lowers the work function of the charged particle source layer 64 at the point 62 of the emitter 60.

By providing an electric field at the point 62, cold field emission is promoted. By providing an electric field at the point 62, thermionic emission (or 'high thermal field emission') is promoted. In an embodiment, when the electric field is generated at the point 62 and the emitter 60 is heated, thermionic emission and cold field emission contribute to the current of charged particles emitted. In an embodiment, thermionic emission contributes at least 95%, optionally at least 98%, optionally at least 99%, and optionally at least 99.5% of the current of the beam of charged particles. The thermionic emission contribution to the current is more stable than the cold field emission contribution. By providing a higher percentage for the thermionic emission contribution, the overall stability of the current of charged particles is improved.

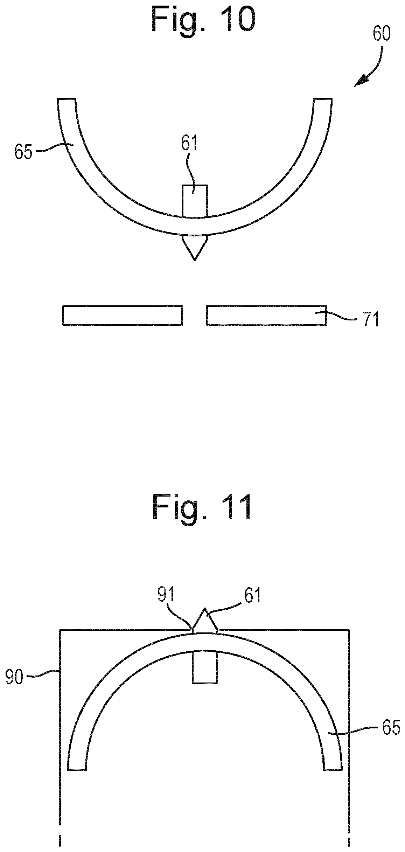

The type of electric field generator 70 is not limited to the electric field generator described here. Other types of electric field generator known to the skilled person may be used. As shown in FIG. 10, in an embodiment an electrode 71 is provided facing the point 62 of the body 61. The electrode 71 may be a plate in which is defined an opening. The opening may allow passage of the beam of charged particles through the electrode 71. In an embodiment, the body 61 is a cathode and the electrode 71 is an anode such than an electric field is applied at the point 62 of the body 61. In an alternative embodiment, a plurality of anodes are provided.

By providing that the charged particle source layer 64 is adjacent to the first metal and applying the electric field at the point 62, the work function of the charged particle source layer 64 is reduced. By heating the point 62 so as to promote thermionic emission, the likelihood of an electron having enough energy to overcome the work function is increased. At an electric field of about 100 MV/m, the work function is reduced by about 0.3 eV.

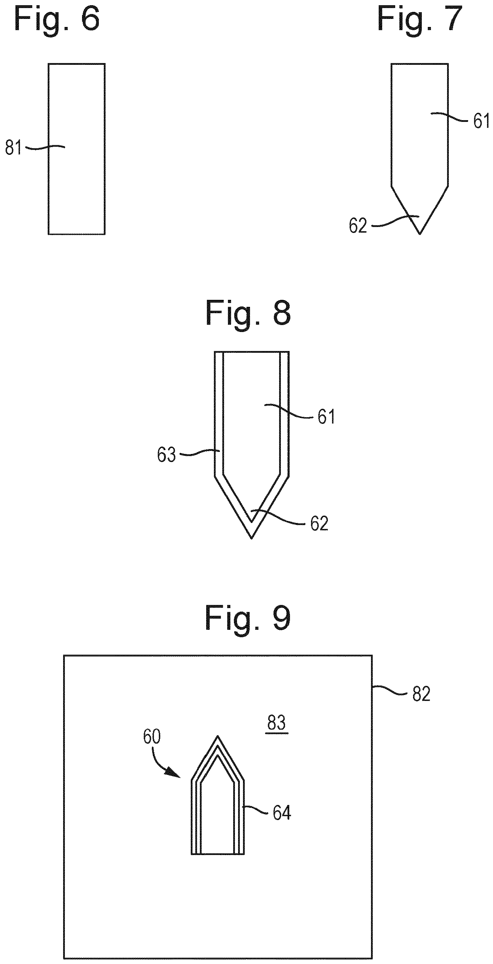

Figures 6 to 8 schematically depict different stages of a method of making an emitter 60 according to an embodiment of the invention. As shown in FIG. 6, in an embodiment the method comprises providing a length of wire 81. In an embodiment the wire 81 has a circular cross-section.

In an embodiment the method comprises sharpening one end of the wire 81 so as to form the body 61, as shown in FIG. 7. By sharpening one end of the wire 81, the point 62 is produced, as shown in FIG. 7. As shown in FIG. 7, in an embodiment the point 62 gradually tapers towards the point. In the arrangement shown in FIG. 7, the tapering angle is approximately equal from the wide-diameter portion of the body 61 up to the point 62. However, this is not necessarily the case. In an embodiment the tapering angle decreases towards the end of the point 62 so as to increase sharpness at the point 62.

The method of sharpening the wire 81 so as to form the point 62 is not limited to method described here. Other methods known to the skilled person may be used. In an embodiment an etching process is used for preparing the point 62. In an embodiment an electrochemical etching process is used. In an embodiment the point 62 comprises a second metal other than the first metal used for the metal layer 63. For example, in an embodiment the metal layer 63 is formed of nickel and the wire 81 from which the body 61 is formed is made of another metal such as tungsten or molybdenum. Metals such as tungsten and molybdenum have higher etching reproducibility compared to nickel. An embodiment of the invention is expected to make manufacturing of the emitter 60 more reproducible.

As shown in FIG. 8, in an embodiment the method comprises applying the metal layer 63 onto the body 61. In an embodiment, the method comprises forming the charged particle source layer 64 on the metal layer 63 so as to produce the emitter 60 as shown in FIG. 4. As shown in FIG. 4, in an embodiment the charged particle source layer 64 covers substantially all of the metal layer 63. In an embodiment, substantially the whole of the projection system facing surface of the emitter 60 is provided by the charged particle source layer 64 on the metal layer 63. However, this is not necessarily the case. In an alternative embodiment, the charged particle source layer 64 covers the metal layer 63 at the point 62 but not at one or more other portions of the metal layer 63 (e.g. at the wide-diameter portion of the emitter 60).

It is not essential for the metal layer 63 to be provided. In an alternative embodiment, the charged particle source layer 64 is formed directly onto the point 62 of the body 61 without an intervening metal layer 63. In an embodiment, the point 62 comprises a metal that reduces the work function of the charged particle source layer 64. For example, in an embodiment the point 62 comprises nickel, cobalt, palladium, copper, silver, iridium or platinum. The body 61 may be made of nickel, cobalt, palladium, copper, silver, iridium or platinum. In an embodiment the body 61 is made of a metal having a lower remanence than nickel. In an embodiment, the body 61 is made of a metal having a higher melting point than nickel.

Figure 9 schematically depicts a method of restoring the charged particle source layer 64 of the emitter 60. As shown in FIG. 9, in an embodiment an environment 83 comprising hydrocarbons is provided. In an embodiment, a chamber 82 is filled with hydrocarbons 83. The chamber provides an environment 83 having a hydrocarbon laden atmosphere. The emitter 60 is placed into the chamber 82. In the chamber 82, the charged particle source layer 64 is in a hydrocarbon laden atmosphere, The charged particle source layer 64 may come into contact with the hydrocarbons in the environment 83. In an embodiment, the point 62 of the body 61 is heated, or is placed into the chamber 82 when it is in a heated state. The charged particle source layer 64 is at least partially restored through contact with the hydrocarbons in the environment 83. In an embodiment the charged particle source layer 64 is restored in situ.

As shown in FIG. 10, in an embodiment the emitter 60 comprises a heating element 65. The heating element 65 is attached to the body 61. In an embodiment, the heating element 65 is welded to the body 61. In an embodiment, the body 61 and the heating element 65 are made of materials that can be welded together. For example, in an embodiment the body 61 and the heating element 65 are made of the same material.

In an embodiment, the heating element 65 forms a resistive heater. An electric current may be passed through the heating element 65 so as to heat the heating element 65. The heating element 65 conducts heat to the body 61 for thermionic emission. For example, in an embodiment the heating element 65 is made of tungsten. In an alternative embodiment, the heating element 65 comprises molybdenum, nickel, cobalt, palladium, copper, silver, iridium or platinum.

As shown in FIG. 11, in an embodiment a charged particle source comprises an electrically conductive suppressor 90. in the suppressor 90 is defined an opening 91 through which the body 61 extends. The opening 91 has a larger dimension, e.g. wider, than the body 61. The body 61 does not contact the suppressor 90. The point 62 of the tip body 61 is external to the suppressor. The suppressor is set a potential relative to the emitter. The point 62 is exposed to electro-magnetic fields external to the suppressor 90, such as the electro-optical elements of the illumination and projection systems. The point 62 may emit the beam of charged particles from the charged particle source layer 64 at the point of the body 61. The suppressor 90 is configured to reduce emission of unwanted charged particles from parts of the emitter 60 other than the point 62. Thus from the perspective of the emitter, the suppressor 90 interferes with electrons emitted from the emitter within the suppressor 90.

In an embodiment, the suppressor 90 is electrically negatively biased relative to the body 61. Unwanted charged particles that may be emitted from the wide-diameter portion of the body 61 may be prevented from being emitted because of the presence of the suppressor 90. The suppressor 90 helps to improve the quality of the beam of charged particles.

The emitting surface at the end of the point 62 of the emitter 60 can come in different sizes. In an embodiment, the emitter surface has a diameter of at least 100nm, optionally at least 200nm, optionally at least 500nm and optionally at least 1000nm. In an embodiment, the emitting surface has a diameter of at most 1000nm, optionally at most 500nm, optionally at most 200nm, and optionally at most 100nm.

Calculations have been performed for an emitter 60 in which the body 61 is made of tungsten and the metal layer 63 is made of nickel. The emitting surface has a diameter of 800nm. The current density Jsc can be calculated using the following formula

$$Jsc(T) := A \cdot T^2 \cdot e^{\frac{-(1.1eV - 0.3eV)}{k_B \cdot T}}$$

where A is the surface area from which the charged particles are emitted, T is the temperature at the point 62 and $k_B$ is the Boltzmann constant.

The brightness Br can be calculated using the formula

$$Br(T) := ec \cdot \frac{Jsc(T)}{\pi \cdot k_B \cdot T}$$

where ec is the charge of an electron $1.602 \times 10^{-19}$ C, Jsc is the current density, $k_B$ is the Boltzmann constant and T is the temperature at the point 62.

Based on the calculations, an embodiment of the invention is expected to increase brightness and/or current density of the beam of charged particles.

As mentioned above, in an embodiment the electron source 201 comprises a gun aperture plate 271. The gun aperture plate 271 defines an aperture. In an embodiment, the aperture is distanced from the point 62 by at most 100mm, optionally at most 50mm, optionally at most 20mm, and optionally at most 10mm. By reducing the distance to the aperture, the maximum effective brightness that can be achieved is increased.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

Clause 1: An emitter configured to emit charged particles, the emitter comprising: a body having a point; a metal layer of a first metal on at least the point; and a charged particle source layer on the metal layer, wherein the point comprises a second metal other than the first metal.

Clause 2: The emitter of clause 1, wherein the second metal has a higher melting point than the first metal.

Clause 3: The emitter of clause 1 or 2, wherein the second metal has a lower remanence than the first metal.

Clause 4: The emitter of any preceding clause, wherein the second metal is a refractory metal.

Clause 5: The emitter of any preceding clause, wherein the first metal is selected from a group consisting of nickel, cobalt, palladium, copper, silver, platinum and iridium.

Clause 6: The emitter of any preceding clause, wherein the charged particle source layer is doped by the first metal.

Clause 7: The emitter of any preceding clause, comprising a heating element configured to apply a heat load to the body so as to promote thermionic charged particle emission.

Clause 8: A charged particle source comprising the emitter of any preceding clause.

Clause 9: The charged particle source of clause 8, comprising an electric field generator configured to generate an electric field at the point so as to lower a work function of the charged particle source layer.

Clause 10: The charged particle source of clause 9, comprising an electrically conductive suppressor comprising a hole through which the body extends such that the point is exposed, wherein the suppressor is configured to reduce emission of charged particles from parts of the emitter other than the point.

Clause 11: An illumination apparatus comprising the charged particle source of any of clauses 8 to 10.

Clause 12: The illumination apparatus of clause 11, comprising an aperture plate defining an aperture.

Clause 13: The illumination apparatus of clause 12, wherein the aperture is distanced from the point by at most 50 mm.

Clause 14: A charged particle beam tool comprising the illumination apparatus of any of clauses 11 to 13.

Clause 15: A charged particle beam inspection apparatus comprising the charged particle beam tool of clause 14.

Clause 16: A method for making an emitter configured to emit charged particles, the method comprising: providing a body having a point; disposing a metal layer of a first metal on at least the point; and forming a charged particle source layer on the metal layer, wherein the body comprises a second metal other than the first metal.

Clause 17: The method of clause 16, wherein the first metal catalyses formation of the charged particle source layer on the metal layer.

Clause 18: The method of clause 16 or 17, comprising: providing an environment comprising hydrocarbons with which the charged particle source layer can come into contact while the point is in a heated state so as to restore the charged particle source layer.

Clause 19: A method of emitting a beam of charged particles, the method comprising: providing an emitter configured to emit charged particles, the emitter comprising a charged particle source layer on a metal at a point of a body of the emitter; and heating the point to a temperature of greater than 500°C so as to promote thermionic emission

Clause 20: The method of clause 19, wherein the emitter comprises: a metal layer of a first metal on at least the point; and the charged particle source layer on the metal layer, wherein the point comprises a second metal other than the first metal.

Clause 21: The method of clause 19, wherein the body comprises an elongate body of the first metal defining the point at one end.

Clause 22: An emitter configured to emit charged particles, the emitter comprising: a body having a point; a metal layer on at least the point; and a charged particle source layer on the metal layer, wherein the point comprises a different metal from the metal layer.

## Claims

1. An emitter configured to emit charged particles, the emitter comprising:

   a body having a point;
   a metal layer of a first metal on at least the point; and
   a charged particle source layer on the metal layer,

   wherein the point comprises a second metal other than the first metal.

2. The emitter of claim 1, wherein the second metal has a higher melting point than the first metal.

3. The emitter of claim 1 or 2, wherein the second metal has a lower remanence than the first metal.

4. The emitter of any preceding claim, wherein the second metal is a refractory metal.

5. The emitter of any preceding claim, wherein the first metal is selected from a group consisting of nickel, cobalt, palladium, copper, silver, platinum and iridium.

6. The emitter of any preceding claim, wherein the charged particle source layer is doped by the first metal.

7. The emitter of any preceding claim, comprising a heating element configured to apply a heat load to the body so as to promote thermionic charged particle emission.

8. A charged particle source comprising the emitter of any preceding claim.

9. The charged particle source of claim 8, comprising an electric field generator configured to generate an electric field at the point so as to lower a work function of the charged particle source layer.

10. The charged particle source of claim 9, comprising an electrically conductive suppressor comprising a hole through which the body extends such that the point is exposed, wherein the suppressor is configured to reduce emission of charged particles from parts of the emitter other than the point.

11. An illumination apparatus comprising the charged particle source of any of claims 8 to 10.

12. The illumination apparatus of claim 11, comprising an aperture plate defining an aperture.

13. A charged particle beam inspection apparatus comprising the illumination apparatus of claim 11 or 12.

14. A method of emitting a beam of charged particles, the method comprising:

   providing an emitter configured to emit charged particles, the emitter comprising a charged particle source layer on a metal at a point of a body of the emitter; and
   heating the point to a temperature of greater than 500°C so as to promote thermionic emission.

15. The method of claim 14, wherein the emitter comprises:

a metal layer of a first metal on at least the point; and
the charged particle source layer on the metal layer,
wherein the point comprises a second metal other than the first metal.

# Fig. 1

# Fig. 2

# Fig. 3

# Fig. 4

# Fig. 5

# Fig. 6

81

# Fig. 7

61

62

# Fig. 8

61

63

62

# Fig. 9

82

83

60

64

# Fig. 10

# Fig. 11

# EP 3 940 740 A1

**Europäisches Patentamt**
**European Patent Office**
**Office européen des brevets**

## EUROPEAN SEARCH REPORT

**Application Number**

EP 20 18 6333

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 328 002 A1 (HEWLETT PACKARD CO [US]) 16 July 2003 (2003-07-16) | 1,5,8-12 | INV. H01J37/075 |
| Y | * paragraphs [0019], [0020], [0027], [0029], [0033], [0035]; figure 6 * | 2,4, 13-15 | H01J3/02 H01J37/073 H01J1/14 |
| Y | C. A. SPINDT ET AL: "Physical properties of thin-film field emission cathodes with molybdenum cones", JOURNAL OF APPLIED PHYSICS, vol. 47, no. 12, 1 December 1976 (1976-12-01), pages 5248-5263, XP055569551, US ISSN: 0021-8979, DOI: 10.1063/1.322600 * IV. EMISSION STABILITY, A. General background, point (a) last sentence; page 5255, right-hand column, lines 15-17; figure 1 * * page 5250, right-hand column, lines 3-7 * * page 5255, left-hand column, lines 7-9 * | 2,4, 13-15 | H01J1/304 |
| A | US 2019/362927 A1 (HILL FRANCES [US] ET AL) 28 November 2019 (2019-11-28) * paragraphs [0044] - [0046]; figure 1 * | 1-15 | TECHNICAL FIELDS SEARCHED (IPC) H01J |
| A | US 7 057 333 B1 (VU THIEN BINH [FR] ET AL) 6 June 2006 (2006-06-06) * column 7, lines 14-26; claim 5; figure 9 * * column 6, lines 16-20 * | 1-15 | |

The present search report has been drawn up for all claims

| Place of search | Date of completion of the search | Examiner |
|---|---|---|
| Munich | 13 January 2021 | Chevrier, Dominique |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 18 6333

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2021

| Patent document cited in search report | | | Publication date | Patent family member(s) | | | Publication date |
|---|---|---|---|---|---|---|---|
| EP | 1328002 | A1 | 16-07-2003 | CN | 1433010 | A | 30-07-2003 |
| | | | | EP | 1328002 | A1 | 16-07-2003 |
| | | | | JP | 2003234061 | A | 22-08-2003 |
| | | | | US | 2003128494 | A1 | 10-07-2003 |
| | | | | US | 2004095868 | A1 | 20-05-2004 |
| | | | | US | 2005029920 | A1 | 10-02-2005 |
| US | 2019362927 | A1 | 28-11-2019 | CN | 112088417 | A | 15-12-2020 |
| | | | | EP | 3766092 | A1 | 20-01-2021 |
| | | | | TW | 202013410 | A | 01-04-2020 |
| | | | | US | 2019362927 | A1 | 28-11-2019 |
| | | | | WO | 2019226966 | A1 | 28-11-2019 |
| US | 7057333 | B1 | 06-06-2006 | AU | 4576200 | A | 05-12-2000 |
| | | | | EP | 1177568 | A1 | 06-02-2002 |
| | | | | FR | 2793602 | A1 | 17-11-2000 |
| | | | | JP | 2003500795 | A | 07-01-2003 |
| | | | | US | 7057333 | B1 | 06-06-2006 |
| | | | | WO | 0070638 | A1 | 23-11-2000 |

EPO FORM P0459

For more details about this annex : see Official Journal of the European Patent Office, No. 12/82

**EP 3 940 740 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **SHAO et al.** A high-brightness large-diameter graphene coated point cathode field emission electron source. *Nature Communications,* 29 March 2018